# EUROPÄISCHE PATENTSCHRIFT

(11) **EP 3 700 993 B1**
(45) Veröffentlichungstag und Bekanntmachung des Hinweises auf die Patenterteilung: **29.01.2025**
(21) Anmeldenummer: 18782363.8
(22) Anmeldetag: 27.09.2018
(51) Int. Cl.: C09J 7/30, C23C 16/40, C23C 16/513, C23C 16/455, C23C 16/54

(54) **PLASMARANDVERKAPSELUNG VON KLEBEBÄNDERN**
PLASMA ENCAPSULATION OF THE EDGES OF ADHESIVE TAPES
ENCAPSULATION AU PLASMA DES BORDS DE RUBANS ADHESIFS

(30) Priorität: 27.10.2017 DE 102017219311
(43) Veröffentlichungstag der Anmeldung: 02.09.2020
(73) Patentinhaber: tesa SE, 22848 Norderstedt (DE)
(72) Erfinder: KOOPS, Arne, 23881 Neu-Lankau (DE); BENDEICH, Manuel, 22527 Hamburg (DE)
(74) Vertreter: tesa SE
(86) Internationale Anmeldenummer: PCT/EP2018/076230
(87) Internationale Veröffentlichungsnummer: WO 2019/081153

(56) Entgegenhaltungen:
- EP-A1- 3 415 580
- WO-A1-2016/131984
- WO-A1-2018/010930
- DE-A1- 102007 006 251

## Beschreibung

Die Erfindung betrifft ein Verfahren zur Reduzierung der Feuchtehinterwanderung in eine Verklebung.

In der US 2016/0028041 A1 ist ein organisches elektronisches Element mit einer Versiegelungsschicht offenbart. Die Versiegelungsschicht umgibt das organische elektronische Element wie beispielsweise OLEDs, die auf einer Substratoberfläche aufgebracht sind, vollständig. Zur Versiegelung des organischen elektronischen Elementes wird ein Flüssigkeitsüberzug, der eine Siliziumkomponente enthält, auf die Außenfläche aufgebracht; danach werden in den Überzug Plasma-Ionen implantiert. Die so entstehende Versiegelungsschicht, besitzt hervorragende Gasbarriere-Eigenschaften. Darüber hinaus ist sie für sichtbares Licht transparent. Durch das Plasma werden diese flüssig aufgebrachten Siliziumverbindungen zur Reaktion gebracht und bilden einen festen Film aus. Nachteilig in dem Verfahren ist jedoch, dass zunächst eine flüssige Schicht aufgebracht werden muss, die dann anschließend in einem zweiten Verfahrensschritt mit einem Plasma behandelt wird. Die Schichtdicke lässt sich dabei nachteiligerweise nicht exakt steuern, und das Verfahren ist relativ aufwendig.

DE 10 2007 006251 A1 offenbart ein Verfahren zur kantenseitigen Passivierung von Haftklebebändern, wobei eine trägerlöse Klebemassenschicht, z. B. auf Acrylatbasis auf eine Polyesterfolie aufgetragen wird und entlang der Seitenkante eine Passivierungsschicht mittels eines Plasmastromes aufgetragen wird. Dem Plasmastrom wird dabei ein Präkursor zugesetzt. WO

2016/131984 A1 offenbart ein Verfahren zur Reduzierung der Wickelspiegelklebrigkeit indem eine Folie mit einem Plasmastrom dem ein Präkursor, wie z. B. HMDSO zugeführt wird, behandelt wird. Die Folie mit der erhaltenen Passivierungsschicht wird dann auf den Wickelspiegel einer Klebebandrolle aufgebracht.

Es ist Aufgabe der vorliegenden Erfindung, ein eingangs genanntes Verfahren zur Reduzierung der Feuchtehinterwanderung in eine Verklebung zu vereinfachen.

Die Aufgabe wird hinsichtlich des Verfahrens durch ein Verfahren zur Reduzierung der Feuchtehinterwanderung in eine Verklebung mit den Merkmalen des Anspruchs 1 gelöst. Klebebänder stehen in unterschiedlichsten Ausführungsformen zur Verfügung. Das Klebeband wird in der Regel als Abschnitt eines langen Klebebandes zur Verfügung gestellt; das Klebeband kann zum Beispiel als Blatt oder als Abschnitt einer Rolle oder günstigerweise als Stanzling oder als Endlosware auf Rollen (archimedische Spirale) zur Verfügung gestellt werden. Das Klebeband kann einfach zusammenhängend ausgebildet sein, oder es können auch Löcher oder Öffnungen in dem Klebeband vorgesehen sein. Das Klebeband kann daher entweder die von seinem äußeren Umfang eingegrenzte Fläche vollständig bedecken oder, wenn es Öffnungen aufweist, auch nur Teile davon bedecken oder freilassen. Das Klebeband ist in zwei Dimensionen deutlich größer als in einer dritten Dimension ausgeformt. Bei den deutlich größeren Dimensionen handelt es sich um die Längenausdehnung und Breitenausdehnung, bei der dritten und deutlich kleineren Dimension um die Dicke oder Höhe des Klebebandes. Die beiden ersten Dimensionen können jedoch auch durchaus gleich groß ausgebildet sein und damit eine kreisförmige, quadratische oder andersartige Fläche aufweisen. Ein Klebeband kann ein- oder mehrschichtig ausgebildet sein, es weist übliche Dicken von etwa 1 µm bis zu 5 mm auf.

Bei einem einschichtigen Aufbau besteht das Klebeband vorzugsweise aus einer Klebmasseschicht; bei einem mehrschichtigen Aufbau kann das Klebeband auch ein Trägermaterial, das in einer Trägerschicht angeordnet ist, umfassen. Das Trägermaterial kann auf einer und auf einer anderen Seite mit einer Klebmasseschicht oder auch nur auf der einen Seite mit einer Klebmasseschicht versehen sein. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen oder dergleichen. Dabei sind für verschiedene Anwendungen unterschiedlichste Träger wie zum Beispiel Folien, Gewebe, Vliese und Papiere mit verschiedenen Kunststoffen kombinierbar.

Als Material der Trägerschicht des Klebebandes werden bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft, aber nicht einschränkend erwähnt seien:
Polyethylen, Polypropylen - insbesondere das durch mono- oder biaxiale Streckung erzeugte orientierte Polypropylen (OPP), cyclische Olefin Copolymere (COC), Polyvinylchlorid (PVC), Polyester - insbesondere Polyethylenterephthalat (PET) und Poylethylennaphthalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Die Trägerschicht kann zudem mit organischen oder anorganischen Beschichtungen oder Schichten kombiniert sein. Dies kann durch übliche Verfahren wie zum Beispiel Lackieren, Drucken, Bedampfen, Sputtern, Co-Extrusion oder Lamination geschehen. Beispielhaft, aber nicht einschränkend erwähnt seien hier etwa Oxide oder Nitride des Siliziums und des Aluminiums, Indium-Zinn-Oxid (ITO) oder Sol-Gel-Beschichtungen.

Bei der Klebmasseschicht kann es sich ebenfalls um alle gängigen Klebmasseschichten handeln.

Der Begriff des "Klebens" beschreibt im Allgemeinen ein Fertigungsverfahren zum stoffschlüssigen Fügen von Substraten. Beim Kleben haftet der Klebstoff durch physikalische Wechselwirkung - gelegentlich auch durch chemische Wechselwirkung - der sogenannten Adhäsion, an den Substraten und verbindet diese zumeist dauerhaft. Da das Kleben einerseits eine großflächige und kraftschlüssige Verbindung der Fügeteile erlaubt und andererseits aufgrund seiner materialschonenden Eigenschaften geeignet ist, nahezu sämtliche Materialien miteinander zu verbinden, werden Klebeverfahren sowohl für den Heimbedarf als auch für die industrielle Anwendung vielfältig angewendet. Immer öfter werden andere Fügeverfahren, wie beispielsweise Schweißen oder Löten, aber auch Verschrauben, durch Klebeverfahren ersetzt.

Vorzugsweise wird eine Haftklebmasseschicht als Klebmasseschicht verwendet. Als Haftklebmassen werden Klebmassen bezeichnet, die bereits unter relativ schwachem Andruck eine dauerhafte Verbindung mit dem Haftgrund erlauben, sie weisen eine Klebkraft größer 1N/cm auf und können nach Gebrauch im Wesentlichen rückstandsfrei vom Haftgrund wieder abgelöst werden. Haftklebmassen wirken bei Raumtemperatur permanent haftklebrig, weisen also eine hinreichend geringe Viskosität und eine hohe Anfassklebrigkeit auf, so dass sie die Oberfläche des jeweiligen Klebegrunds bereits bei geringem Andruck benetzen. Die Verklebbarkeit entsprechender Klebmassen beruht auf ihren adhäsiven Eigenschaften und die Wiederablösbarkeit auf ihren kohäsiven Eigenschaften.

Haftklebmasse umfasst eine Basis und eine vernetzbare Komponente, auch als Reaktivharz bezeichnet.

Als Basis für Haftklebmassen kommen verschiedene Materialien, insbesondere unpolare Elastomere, in Frage.

Unpolare Elastomere wie beispielsweise Vinylaromaten-Blockcopolymere zeichnen sich dadurch aus, dass sie in unpolaren Lösungsmitteln gelöst werden können, das heißt in Lösungsmitteln und/oder Lösungsmittelgemischen, deren Polarität Ethylacetat entspricht oder die unpolarer sind. Dies sind insbesondere Lösungsmittel und/oder Lösungsmittelgemische mit einer Dielektrizitätskonstante von kleiner 6,1 [http://en.wikipedia.org/wiki/Solvent vom 11 Oktober 2017] und/oder mit Hansenparametern δP Polar ≤ 5,3; δH Hydrogen bonding ≤ 7,2 [Abbott, Steven and Hansen, Charles M. (2008) Hansen Solubility Parameters in Practice, ISBN 0-9551220-2-3 oder Hansen, Charles M. (2007) Hansen solubility parameters: a user's handbook CRC Press, ISBN 0-8493-7248-8].

Kommen als Elastomere Blockcopolymere zum Einsatz, dann enthalten diese zumindest eine Blocksorte mit einer Erweichungstemperatur von größer 40 °C wie zum Beispiel Vinylaromaten (auch teil- oder vollhydrierte Varianten), Methylmethacrylat, Cyclohexylmethacrylat, Isobornylmethacrylat und Isobornylacrylat.

Weiter vorzugsweise enthält das Blockcopolymer eine Blocksorte mit einer Erweichungstemperatur von kleiner - 20 °C.

Beispiele für Polymerblöcke mit niedrigen Erweichungstemperaturen ("Weichblöcke") sind Polyether wie zum Beispiel Polyethylenglykol, Polypropylenglykol oder Polytetrahydrofuran, Polydiene wie zum Beispiel Polybutadien oder Polyisopren, (teil)hydrierte Polydiene wie zum Beispiel Polyethylenbutylen, Polyethylenpropylen oder Polybutylenbutadien, Polybutylen, Polyisobutylen, Polyalkylvinylether, Polymerblöcke α,β-ungesättigter Ester wie insbesondere Acrylat-Copolymere.

Der Weichblock ist dabei in einer Auslegung unpolar aufgebaut und enthält dann bevorzugt Butylen oder Isobutylen oder hydrierte Polydiene als Homopolymerblock oder Copolymerblock, letztere vorzugsweise mit sich selbst oder miteinander oder mit weiteren besonders bevorzugt unpolaren Comonomeren copolymerisiert. Als unpolare Comonomere sind beispielsweise (teil-)hydriertes Polybutadien, (teil-)hydriertes Polyisopren und/oder Polyolefine geeignet.

Die vernetzbare Komponente, auch als Reaktivharz bezeichnet, besteht aus einem cyclischen Ether und eignet sich für die strahlenchemische und gegebenenfalls thermische Vernetzung mit einer Erweichungstemperatur von kleiner 40 °C, bevorzugt von kleiner 20 °C.

Bei den Reaktivharzen auf Basis cyclischer Ether handelt es sich insbesondere um Epoxide, also Verbindungen, die zumindest eine Oxiran-Gruppe tragen, oder Oxetane. Sie können aromatischer oder insbesondere aliphatischer oder cycloaliphatischer Natur sein.

Einsetzbare Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandiglycidylether und Derivate, 1,3-Propandiglycidylether und Derivate, 1,4-Butandioldiglycidylether und Derivate, höhere 1,n-Alkandiglycidylether und Derivate, Bis-[(3,4-epoxycyclohexyl)methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidylether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks, 2-(7-Oxabicyclo)Spiro[1,3-dioxane-5,3'-[7]oxabicyclo[4.1.0]-heptane], 1,4-Bis((2,3-epoxypropoxy)methyl)cyclohexane.

Reaktivharze können in ihrer monomeren oder auch dimeren, trimeren, usw. bis hin zu ihrer oligomeren Form eingesetzt werden.

Gemische von Reaktivharzen untereinander aber auch mit anderen coreaktiven Verbindungen wie Alkoholen (monofunktionell oder mehrfach funktionell) oder Vinylethern (monofunktionell oder mehrfach funktionell) sind ebenfalls möglich.

Besonders bevorzugt handelt es sich bei dem Klebeband um eine Klebebandrolle, die aus dem *ACX^{plus}*-Sortiment der Firma tesa stammt.

Derartige Klebebänder umfassen vorzugsweise eine Trägerschicht, die auch als Hartphase bezeichnet wird. Die Polymerbasis der Hartphase ist bevorzugt ausgewählt aus der Gruppe bestehend aus Polyvinylchloriden (PVC), Polyethylenterephthalaten (PET), Polyurethanen, Polyolefinen, Polybutylenterephthalaten (PBT), Polycarbonaten, Polymethylmethacrylaten (PMMA), Polyvinylbutyralen (PVB), Ionomeren und Mischungen aus zwei oder mehreren der vorstehend aufgeführten Polymere. Besonders bevorzugt ist die Polymerbasis der Hartphase ausgewählt aus der Gruppe bestehend aus Polyvinylchloriden, Polyethylenterephthalaten, Polyurethanen, Polyolefinen und Mischungen aus zwei oder mehreren der vorstehend aufgeführten Polymere. Die Hartphase ist im Wesentlichen eine Polymerfolie, deren Polymerbasis aus den vorstehenden Materialien ausgewählt ist. Unter einer "Polymerfolie" wird eine dünne, flächige, flexible, aufwickelbare Bahn verstanden, deren Materialbasis im Wesentlichen von einem oder mehreren Polymer(en) gebildet wird.

Unter "Polyurethanen" werden in weitgefasstem Sinne polymere Substanzen verstanden, in denen sich wiederholende Einheiten durch Urethan-Gruppierungen -NH-CO-O- miteinander verknüpft sind.

Unter "Polyolefinen" werden Polymere verstanden, die stoffmengenbezogen zu mindestens 50 % Wiederholungseinheiten der allgemeinen Struktur -[-CH2-CR1R2-]n- enthalten, worin R1 für ein Wasserstoffatom und R2 für ein Wasserstoffatom oder für eine lineare oder verzweigte, gesättigte aliphatische oder cycloaliphatische Gruppe steht. Soweit die Polymerbasis der Hartphase Polyolefine umfasst, handelt es sich bei diesen besonders bevorzugt um Polyethylene, insbesondere um Polyethylene mit ultrahoher Molmasse (UHMWPE).

Unter der "Polymerbasis" wird das Polymer beziehungsweise werden die Polymere verstanden, das/die den größten Gewichtsanteil aller in der betreffenden Schicht beziehungsweise Phase enthaltenen Polymere ausmacht/ausmachen.

Die Dicke der Hartphase beträgt insbesondere ≤ 150 µm. Bevorzugt beträgt die Dicke der Hartphase 10 bis 150 µm, besonders bevorzugt 30 bis 120 µm und insbesondere 50 bis 100 µm, beispielsweise 70 bis 85 µm. Unter der "Dicke" wird die Ausdehnung der betreffenden Schicht beziehungsweise Phase entlang der z-Ordinate eines gedachten Koordinatensystems verstanden, bei dem die durch die Maschinenrichtung und die Querrichtung zur Maschinenrichtung aufgespannte Ebene die x-y-Ebene bildet. Die Dicke wird durch Messung an mindestens fünf verschiedenen Stellen der betreffenden Schicht beziehungsweise Phase und anschließende Bildung des arithmetischen Mittels aus den erhaltenen Messergebnissen ermittelt. Die Dickenmessung der Hartphase erfolgt dabei in Einklang mit DIN EN ISO 4593.

Derartige Klebebänder können weiterhin eine Klebmasseschicht oder Weichphase aufweisen, die einen Polymerschaum, eine viskoelastische Masse und/oder eine elastomere Masse umfassen. Die Polymerbasis der Weichphase ist bevorzugt ausgewählt aus Polyolefinen, Polyacrylaten, Polyurethanen und Mischungen aus zwei oder mehreren der vorstehend aufgeführten Polymere.

In der einfachsten Variante besteht das Klebeband nur aus einer Weichphase.

Unter einem "Polymerschaum" wird ein Gebilde aus gasgefüllten kugel- oder polyederförmigen Zellen verstanden, welche durch flüssige, halbflüssige, hochviskose oder feste Zellstege begrenzt werden; ferner ist der Hauptbestandteil der Zellstege ein Polymer oder ein Gemisch mehrerer Polymere.

Unter einer "viskoelastischen Masse" wird ein Material verstanden, das neben Merkmalen der reinen Elastizität (Zurückkehren in den Ausgangszustand nach äußerer mechanischer Einwirkung) auch Merkmale einer viskosen Flüssigkeit zeigt, beispielsweise das Auftraten innerer Reibung bei Deformation. Insbesondere werden Haftklebemassen auf Polymerbasis als viskoelastische Massen angesehen.

Unter einer "elastomeren Masse" wird ein Material verstanden, das gummielastisches Verhalten aufweist und bei 20 °C wiederholt auf mindestens das Zweifache seiner Länge gedehnt werden kann und nach Aufhebung des für die Dehnung erforderlichen Zwanges sofort wieder annähernd seine Ausgangsdimension einnimmt.

Bezüglich des Verständnisses der Begriffe "Polymerbasis", "Polyurethane" und "Polyolefine" gilt das oben Gesagte. Unter "Polyacrylaten" werden Polymere verstanden, deren stoffmengenbezogene Monomerbasis zu mindestens 50 % aus Acrylsäure, Methacrylsäure, Acrylsäureestern und/oder Methacrylsäureestern besteht, wobei Acrylsäureester und/oder Methacrylsäureester zumindest anteilig generell und bevorzugt zu mindestens 50 % enthalten sind. Insbesondere wird unter einem "Polyacrylat" ein Polymerisat verstanden, welches durch radikalische Polymerisation von Acryl- und/oder Methylacrylmonomeren sowie gegebenenfalls weiteren copolymerisierbaren Monomeren erhältlich ist.

Besonders bevorzugt ist die Polymerbasis der Weichphase ausgewählt aus Polyolefinen, Polyacrylaten und Mischungen aus zwei oder mehreren der vorstehend aufgeführten Polymere. Sofern Polyolefine zu der Polymerbasis der Weichphase gehören, sind diese bevorzugt ausgewählt aus Polyethylenen, Ethylen-Vinylacetat-Copolymeren (EVA) und Gemischen aus Polyethylenen und Ethylen-Vinylacetat-Copolymeren (PE/EVA-Blends). Die Polyethylene können dabei verschiedene Polyethylen-Typen sein, beispielsweise HDPE, LDPE, LLDPE, Blends aus diesen Polyethylen-Typen und/oder Gemische davon.

In einer Ausführungsform umfasst die Weichphase einen Schaum und jeweils eine ober- und unterhalb der geschäumten Schicht angeordnete Haftklebeschicht, wobei die Polymerbasis des Schaums aus einem oder mehreren Polyolefin(en) besteht und die Polymerbasis der Haftklebeschichten aus einem oder mehreren Polyacrylat(en) besteht. Besonders bevorzugt besteht die Polymerbasis des Schaums dabei aus einem oder mehreren Polyethylen(en), Ethylen-Vinylacetat-Copolymer(en) und Gemischen aus einem oder mehreren Polyethylen(en) und/oder Ethylen-Vinylacetat-Copolymer(en). Ganz besonders bevorzugt besteht die Polymerbasis des Schaums dabei aus einem oder mehreren Polyethylen(en).

Der Polyolefin-basierte Schaum selbst ist nicht oder nur sehr wenig haftklebrig. Der Verbund mit der Hartphase beziehungsweise dem Substrat wird daher vorteilhaft durch die Haftklebeschichten bewirkt. Die Schäumung des Polyolefin-basierten Ausgangsmaterials des Schaums wird bevorzugt durch zugesetztes Treibgas im Sinne einer physikalischen Schäumung und/oder durch ein chemisches Schäumungsmittel, beispielsweise durch Azodicarbonsäurediamin, hervorgerufen.

In einer weiteren Ausführungsform ist die Weichphase ein haftklebriger Polymerschaum, dessen Polymerbasis aus einem oder mehreren Polyacrylaten besteht. "Haftklebriger Schaum" bedeutet, dass der Schaum selbst eine Haftklebmasse ist und somit ein Auftrag einer zusätzlichen Haftklebeschicht nicht erforderlich ist. Dies ist vorteilhaft, weil im Herstellungsprozess weniger Schichten zusammengefügt werden müssen und das Risiko von Ablösungserscheinungen und anderen unerwünschten Phänomenen an den Schichtgrenzen sinkt.

Unter einer "Haftklebmasse" wird ein Material verstanden, dessen abgebundener Film bei Raumtemperatur in trockenem Zustand permanent klebrig und klebfähig bleibt, wobei eine Verklebung durch leichten Anpressdruck sofort auf einer Vielzahl unterschiedlicher Substrate erfolgt.

Die Polyacrylate sind bevorzugt erhältlich durch zumindest anteiliges Einpolymerisieren von funktionellen, mit Epoxidgruppen vernetzungsfähigen Monomeren. Besonders bevorzugt handelt es sich dabei um Monomere mit Säuregruppen (besonders Carbonsäure-, Sulfonsäure oder Phosphonsäuregruppen) und/oder Hydroxygruppen und/oder Säureanhydridgruppen und/oder Epoxidgruppen und/oder Amingruppen; insbesondere bevorzugt sind carbonsäuregruppenhaltige Monomere. Es ist ganz besonders vorteilhaft, wenn die Polyacrylate einpolymerisierte Acrylsäure und/oder Methacrylsäure aufweisen. All diese Gruppen weisen eine Vernetzungsfähigkeit mit Epoxidgruppen auf, wodurch die Polyacrylate vorteilhaft einer thermischen Vernetzung mit eingebrachten Epoxiden zugänglich werden.

Weitere Monomere, die als Comonomere für die Polyacrylate verwendet werden können, sind neben Acrylsäure- und/oder Methacrylsäureestern mit bis zu 30 C-Atomen beispielsweise Vinylester von bis zu 20 C-Atome enthaltenden Carbonsäuren, Vinylaromate mit bis zu 20 C-Atomen, ethylenisch ungesättigte Nitrile, Vinylhalogenide, Vinylether von 1 bis 10 C-Atome enthaltenden Alkoholen, aliphatische Kohlenwasserstoffe mit 2 bis 8 C-Atomen und 1 oder 2 Doppelbindungen oder Mischungen dieser Monomere.

Die Eigenschaften des betreffenden Polyacrylats lassen sich insbesondere über eine Variation der Glasübergangstemperatur des Polymers durch unterschiedliche Gewichtsanteile der einzelnen Monomere beeinflussen. Die Polyacrylate können vorzugsweise auf die folgende Monomerzusammensetzung zurückgeführt werden:
(a) Acrylsäureester und/oder Methacrylsäureester der folgenden Formel

   CH₂ = C(R')(COOR")

   wobei R^{I} = H oder CH₃ und R^{II} ein Alkylrest mit 4 bis 14 C-Atomen ist,
(b) olefinisch ungesättigte Monomere mit funktionellen Gruppen der für eine Reaktivität mit Epoxidgruppen bereits definierten Art,
(c) optional weitere Acrylate und/oder Methacrylate und/oder olefinisch ungesättigte Monomere, die mit der Komponente (a) copolymerisierbar sind.

Bevorzugt beruhen die Polyacrylate auf einer Monomerzusammensetzung, in der die Monomere der Komponente (a) mit einem Anteil von 45 bis 99 Gew.-%, die Monomere der Komponente (b) mit einem Anteil von 1 bis 15 Gew.-% und die Monomere der Komponente (c) mit einem Anteil von 0 bis 40 Gew.-% enthalten sind (die Angaben sind bezogen auf die Monomermischung für das "Basispolymer", also ohne Zusätze eventueller Additive zu dem fertigen Polymer, wie Harze etc.). In diesem Fall weist das Polymerisationsprodukt eine Glastemperatur ≤ 15 °C (DMA bei geringen Frequenzen) und haftklebende Eigenschaften auf.

Die Monomere der Komponente (a) sind insbesondere weichmachende und/oder unpolare Monomere. Vorzugsweise werden als Monomere (a) Acryl- und Methacrylsäureester mit Alkylgruppen bestehend aus 4 bis 14 C-Atomen, besonders bevorzugt 4 bis 9 C-Atomen, eingesetzt. Beispiele für derartige Monomere sind n-Butylacrylat, n-Butylmethacrylat, n-Pentylacrylat, n-Pentylmethacrylat, n-Amylacrylat, n-Hexylacrylat, n-Hexylmethacrylat, n-Heptylacrylat, n-Octylacrylat, n-Octylmethacrylat, n-Nonylacrylat, Isobutylacrylat, Isooctylacrylat, Isooctylmethacrylat und deren verzweigte Isomere, wie zum Beispiel 2 Ethylhexylacrylat oder 2 Ethylhexylmethacrylat.

Die Monomere der Komponente (b) sind insbesondere olefinisch ungesättigte Monomere mit funktionellen Gruppen, insbesondere mit funktionellen Gruppen, die eine Reaktion mit Epoxidgruppen eingehen können.

Bevorzugt werden für die Komponente (b) Monomere mit funktionellen Gruppen eingesetzt, die ausgewählt sind aus der Gruppe umfassend: Hydroxy-, Carboxy-, Sulfonsäure- oder Phosphonsäuregruppen, Säureanhydride, Epoxide, Amine.

Besonders bevorzugte Beispiele für Monomere der Komponente (b) sind Acrylsäure, Methacrylsäure, Itaconsäure, Maleinsäure, Fumarsäure, Crotonsäure, Aconitsäure, Dimethylacrylsäure, β-Acryloyloxypropionsäure, Trichloracrylsäure, Vinylessigsäure, Vinylphosphonsäure, Itasconsäure, Maleinsäureanhydrid, Hydroxyethylacrylat, Hydroxypropylacrylat, Hydroxyethylmethacrylat, Hydroxypropylmethacrylat, 6-Hydroxyhexylmethacrylat, Allylalkohol, Glycidylacrylat, Glycidylmethacrylat.

Prinzipiell können als Komponente (c) alle vinylisch funktionalisierten Verbindungen eingesetzt werden, die mit der Komponente (a) und/oder der Komponente (b) copolymerisierbar sind. Die Monomere der Komponente (c) können zur Einstellung der Eigenschaften der resultierenden Haftklebmasse dienen.

Beispielhafte Monomere der Komponente (c) sind:
Methylacrylat, Ethylacrylat, Propylacrylat, Methylmethacrylat, Ethylmethacrylat, Benzylacrylat, Benzylmethacrylat, sec-Butylacrylat, tert-Butylacrylat, Phenylacrylat, Phenylmethacrylat, Isobornylacrylat, Isobornylmethacrylat, tert-Butylphenylacrylat, tert-Butylaphenylmethacrylat, Dodecylmethacrylat, Isodecylacrylat, Laurylacrylat, n-Undecylacrylat, Stearylacrylat, Tridecylacrylat, Behenylacrylat, Cyclohexylmethacrylat, Cyclopentylmethacrylat, Phenoxyethylacrlylat, Phenoxyethylmethacrylat, 2-Butoxyethyl-methacrylat, 2-Butoxyethylacrylat, 3,3,5-Trimethylcyclohexylacrylat, 3,5-Dimethyl-adamantylacrylat, 4-Cumylphenylmethacrylat, Cyanoethylacrylat, Cyanoethylmethacrylat, 4-Biphenylacrylat, 4-Biphenylmethacrylat, 2-Naphthylacrylat, 2-Naphthylmethacrylat, Tetrahydrofufurylacrylat, Diethylaminoethylacrylat, Diethylaminoethylmethacrylat, Dimethylaminoethyl-acrylat, Dimethylaminoethylmethacrylat, 2-Butoxyethylacrylat, 2-Butoxyethylmethacrylat, 3-Methoxyacrylsäuremethylester, 3-Methoxybutylacrylat, Phenoxyethylacrlylat, Phenoxyethylmethacrylat, 2-Phenoxyethylmethacrylat, Butyldiglykolmethacrylat, Ethylenglycolacrylat, Ethylenglycolmonomethylacrylat, Methoxy Polyethylenglykolmethacrylat 350, Methoxy Polyethylenglykolmethacrylat 500, Propylenglycolmonomethacrylat, Butoxydiethylenglykolmethacrylat, Ethoxytriethylen-glykolmethacrylat, Octafluoropentylacrylat, Octafluoropentylmethacrylat, 2,2,2-Trifluoro-ethylmethacrylat, 1,1,1,3,3,3-Hexafluoroisopropylacrylat, 1,1,1,3,3,3-Hexafluoro-isopropylmethacrylat, 2,2,3,3,3-Pentafluoropropylmethacrylat, 2,2,3,4,4,4-Hexafluoro-butylmethacrylat, 2,2,3,3,4,4,4-Heptafluorobutylacrylat, 2,2,3,3,4,4,4-Heptafluoro-butylmethacrylat, 2,2,3,3,4,4,5,5,6,6,7,7,8,8,8-Pentadecafluorooctylmethacrylat, Dimethyl-aminopropylacrylamid, Dimethylaminopropylmethacrylamid, N-(1-Methylundecyl)acrylamid, N-(n-Butoxymethyl)acrylamid, N-(Butoxymethyl)methacrylamid, N-(Ethoxymethyl)acrylamid, N-(n-Octadecyl)acrylamid, weiterhin N,N-Dialkyl-substituierte Amide, wie beispielsweise N,N-Dimethylacrylamid, N,N-Dimethylmethacrylamid, N-Benzylacrylamide, N-Isopropylacrylamid, N-tert-Butylacrylamid, N-tert-Octylacrylamid, N-Methylolacrylamid, N-Methylolmethacrylamid, Acrylnitril, Methacrylnitril, Vinylether, wie Vinylmethylether, Ethylvinylether, Vinylisobutylether, Vinylester, wie Vinylacetat, Vinylchlorid, Vinylhalogenide, Vinylidenchlorid, Vinylidenhalogenide, Vinylpyridin, 4-Vinylpyridin, N-Vinylphthalimid, N-Vinyllactam, N-Vinylpyrrolidon, Styrol, a- und p-Methylstyrol, a-Butylstyrol, 4-n-Butylstyrol, 4-n-Decylstyrol, 3,4-Dimethoxystyrol. Makromonomere wie 2-Polystyrolethylmethacrylat (Molekulargewicht M_{w} von 4000 bis 13000 g/mol), Poly(methylmethacrylat)ethylmethacrylat (M_{w} von 2000 bis 8000 g/mol).

Monomere der Komponente (c) können vorteilhaft auch derart gewählt werden, dass sie funktionelle Gruppen enthalten, die eine nachfolgende strahlenchemische Vernetzung (beispielsweise durch Elektronenstrahlen, UV) unterstützen. Geeignete copolymerisierbare Photoinitiatoren sind zum Beispiel Benzoinacrylat und acrylatfunktionalisierte Benzophenonderivate. Monomere, die eine Vernetzung durch Elektronenbestrahlung unterstützen, sind zum Beispiel Tetrahydrofufurylacrylat, N-tert-Butylacrylamid und Allylacrylat.

Die Herstellung der Polyacrylate ("Polyacrylate" wird im Rahmen der Erfindung als synonym mit "Poly(meth)acrylate" verstanden) kann nach dem dem Fachmann geläufigen Verfahren geschehen, insbesondere vorteilhaft durch konventionelle radikalische Polymerisationen oder kontrollierte radikalische Polymerisationen. Die Polyacrylate können durch Copolymerisation der monomeren Komponenten unter Verwendung der üblichen Polymerisationsinitiatoren sowie gegebenenfalls von Reglern hergestellt werden, wobei bei den üblichen Temperaturen in Substanz, in Emulsion, zum Beispiel in Wasser oder flüssigen Kohlenwasserstoffen, oder in Lösung polymerisiert wird.

Vorzugsweise werden die Polyacrylate durch Polymerisation der Monomere in Lösungsmitteln, insbesondere in Lösungsmitteln mit einem Siedebereich von 50 bis 150 °C, vorzugsweise von 60 bis 120 °C unter Verwendung der üblichen Mengen an Polymerisationsinitiatoren, die im allgemeinen bei 0,01 bis 5, insbesondere bei 0,1 bis 2 Gew.-% (bezogen auf das Gesamtgewicht der Monomeren) liegen, hergestellt.

Prinzipiell eignen sich alle dem Fachmann geläufigen, üblichen Initiatoren. Beispiele für Radikalquellen sind Peroxide, Hydroperoxide und Azoverbindungen, zum Beispiel Dibenzoylperoxid, Cumolhydroperoxid, Cyclohexanonperoxid, Di-t-butylperoxid, Cyclohexylsulfonylacetylperoxid, Diisopropylpercarbonat, t-Butylperoktoat, Benzpinacol. In einer sehr bevorzugten Vorgehensweise wird als radikalischer Initiator 2,2'-Azobis(2-methylbutyronitril) (Vazo^{®} 67^{™} der Firma DuPont) oder 2,2'-Azobis(2-methylpropionitril) (2,2'-Azobisisobutyronitril; AIBN; Vazo^{®} 64^{™} der Firma DuPont) verwendet.

Als Lösungsmittel für die Herstellung der Polyacrylate kommen Alkohole wie Methanol, Ethanol, N- und Iso-Propanol, N- und Iso-Butanol, vorzugsweise Isopropanol und/oder Isobutanol, sowie Kohlenwasserstoffe wie Toluol und insbesondere Benzine eines Siedebereichs von 60 bis 120 °C in Frage. Ferner können Ketone wie vorzugsweise Aceton, Methylethylketon, Methylisobutylketon und Ester wie Essigsäureethylester sowie Gemische von Lösungsmitteln der genannten Art eingesetzt werden, wobei Gemische, die Isopropanol, insbesondere in Mengen von 2 bis 15 Gew.-%, bevorzugt 3 bis 10 Gew.-%, bezogen auf das eingesetzte Lösungsmittelgemisch, enthalten, vorgezogen werden.

Bevorzugt erfolgt nach der Herstellung (Polymerisation) der Polyacrylate eine Aufkonzentration, und die weitere Verarbeitung der Polyacrylate erfolgt im Wesentlichen lösemittelfrei. Die Aufkonzentration des Polymerisats kann in Abwesenheit von Vernetzer- und Beschleunigersubstanzen geschehen. Es ist aber auch möglich, eine dieser Verbindungsklassen dem Polymerisat bereits vor der Aufkonzentration zuzusetzen, so dass die Aufkonzentration dann in Gegenwart dieser Substanz(en) erfolgt.

Die Polymerisate können nach dem Aufkonzentrationsschritt in einen Compounder überführt werden. Gegebenenfalls können die Aufkonzentration und die Compoundierung auch im selben Reaktor stattfinden.

Die gewichtsmittleren Molekulargewichte M_{w} der Polyacrylate liegen bevorzugt in einem Bereich von 20.000 bis 2.000.000 g/mol; sehr bevorzugt in einem Bereich von 100.000 bis 1.000.000 g/mol, äußerst bevorzugt in einem Bereich von 150.000 bis 500.000 g/mol (die Angaben des mittleren Molekulargewichtes M_{w} und der Polydispersität PD in dieser Schrift beziehen sich auf die Bestimmung per Gelpermeationschromatographie. Als Eluent wurde THF mit 0,1 Vol.-% Trifluoressigsäure eingesetzt. Die Messung erfolgte bei 25 °C. Als Vorsäule wurde PSS-SDV, 5 µm, 10³ Å, ID 8,0 mm × 50 mm verwendet. Zur Auftrennung wurden die Säulen PSS-SDV, 5 µm, 10³ Å, 10⁵ Å und 10⁶ Å mit jeweils ID 8,0 mm × 300 mm eingesetzt. Die Probenkonzentration betrug 4 g/l, die Durchflussmenge 1,0 ml pro Minute. Es wurde gegen PMMA-Standards gemessen (µ = µm; 1 Å = 10⁻¹⁰ m). Dazu kann es vorteilhaft sein, die Polymerisation in Gegenwart geeigneter Polymerisationsregler wie Thiole, Halogenverbindungen und/oder Alkohole durchzuführen, um das gewünschte mittlere Molekulargewicht einzustellen.

Das Polyacrylat hat vorzugsweise einen K-Wert von 30 bis 90, besonders bevorzugt von 40 bis 70, gemessen in Toluol (1%ige Lösung, 21 °C). Der K-Wert nach Fikentscher ist ein Maß für das Molekulargewicht und die Viskosität des Polymerisats.

Besonders geeignet sind Polyacrylate, die eine enge Molekulargewichtsverteilung (Polydispersität PD < 4) haben. Diese Massen haben trotz eines relativ niedrigen Molekulargewichts nach dem Vernetzen eine besonders gute Scherfestigkeit. Zudem ermöglicht die niedrigere Polydispersität eine leichtere Verarbeitung aus der Schmelze, da die Fließviskosität gegenüber einem breiter verteilten Polyacrylat bei weitgehend gleichen Anwendungseigenschaften geringer ist. Eng verteilte Poly(meth)acrylate können vorteilhaft durch anionische Polymerisation oder durch kontrollierte radikalische Polymerisationsmethoden hergestellt werden, wobei letztere besonders gut geeignet sind. Beispiele für derartige Polyacrylate, die nach dem RAFT-Verfahren hergestellt werden, sind in der US 6,765,078 B2 und der US 6,720,399 B2 beschrieben. Auch über N-Oxyle lassen sich entsprechende Polyacrylate herstellen, wie beispielsweise in der EP 1 311 555 B1 beschrieben ist. Auch die Atom Transfer Radical Polymerization (ATRP) lässt sich in vorteilhafter Weise zur Synthese eng verteilter Polyacrylate einsetzen, wobei als Initiator bevorzugt monofunktionelle oder difunktionelle, sekundäre oder tertiäre Halogenide und zur Abstraktion des(r) Halogenids(e) Cu-, Ni-, Fe-, Pd-, Pt-, Ru-, Os-, Rh-, Co-, Ir-, Ag- oder Au-Komplexe eingesetzt werden. Die unterschiedlichen Möglichkeiten der ATRP sind in den Schriften US 5,945,491 A, US 5,854,364 A und US 5,789,487 A beschrieben.

Die Monomere zur Herstellung der Polyacrylate enthalten bevorzugt anteilig funktionelle Gruppen, die geeignet sind, mit Epoxidgruppen Verknüpfungsreaktionen einzugehen. Dies ermöglicht vorteilhaft eine thermische Vernetzung der Polyacrylate durch Reaktion mit Epoxiden. Unter Verknüpfungsreaktionen werden insbesondere Additions- und Substitutionsreaktionen verstanden. Bevorzugt kommt es also zu einer Verknüpfung der die funktionellen Gruppen tragenden Bausteine mit Epoxidgruppen tragenden Bausteinen, insbesondere im Sinne einer Vernetzung der die funktionellen Gruppen tragenden Polymerbausteine über Epoxidgruppen tragende Vernetzermoleküle als Verknüpfungsbrücken. Bei den epoxidgruppenhaltigen Substanzen handelt es sich bevorzugt um multifunktionelle Epoxide, also solche mit mindestens zwei Epoxidgruppen; entsprechend kommt es bevorzugt insgesamt zu einer mittelbaren Verknüpfung der die funktionellen Gruppen tragenden Bausteine.

Das Polyacrylat beziehungsweise die Polyacrylate sind bevorzugt durch Verknüpfungsreaktionen - insbesondere im Sinne von Additions- oder Substitutionsreaktionen - von in ihnen enthaltenen funktionellen Gruppen mit thermischen Vernetzern vernetzt. Es können alle thermischen Vernetzer verwendet werden, die sowohl eine ausreichend lange Verarbeitungszeit gewährleisten, so dass es nicht zu einer Vergelung während des Verarbeitungsprozesses kommt, als auch zu einer schnellen Nachvernetzung des Polymers auf den gewünschten Vernetzungsgrad bei niedrigeren Temperaturen als der Verarbeitungstemperatur, insbesondere bei Raumtemperatur, führen. Möglich ist beispielsweise eine Kombination aus Carboxyl-, Amin- und/oder Hydroxygruppen enthaltenden Polymeren und Isocyanten als Vernetzer, insbesondere den in der EP 1 791 922 A1 beschriebenen aliphatischen oder mit Aminen deaktivierten trimerisierten Isocyanaten.

Geeignete Isocyanate sind insbesondere trimerisierte Derivate von MDI [4,4-Methylendi(phenylisocyanat)], HDI [Hexamethylendiisocyanat, 1,6-Hexylendiisocyanat] und/oder IPDI [Isophorondiisocyanat, 5-Isocyanato-1-isocyanatomethyl-1,3,3-trimethylcyclohexan], beispielsweise die Typen Desmodur^{®} N3600 und XP2410 (jeweils BAYER AG: Aliphatische Polyisocyanate, niedrigviskose HDI-Trimerisate). Ebenfalls geeignet ist die oberflächendeaktivierte Dispersion von mikronisiertem trimerisiertem IPDI BUEJ 339^{®}, jetzt HF9 ^{®} (BAYER AG).

Grundsätzlich zur Vernetzung geeignet sind aber auch andere Isocyanate wie Desmodur VL 50 (Polyisocyanate auf MDI-Basis, Bayer AG), Basonat F200WD (aliphatisches Polyisocyanat, BASF AG), Basonat HW100 (wasseremulgierbares polyfunktionelles Isocyanat auf HDI-Basis, BASF AG), Basonat HA 300 (allophanatmodifiziertes Polyisocyanat auf Isocyanurat. HDI-Basis, BASF) oder Bayhydur VPLS2150/1 (hydrophil modifiziertes IPDI, Bayer AG).

Bevorzugt wird als thermischer Vernetzer beispielsweise das trimerisierte Isocyanat, zu 0,1 bis 5 Gew.-%, insbesondere zu 0,2 bis 1 Gew.-%, bezogen auf die Gesamtmenge des zu vernetzenden Polymers, eingesetzt.

Bevorzugt umfasst der thermische Vernetzer mindestens eine epoxidgruppenhaltige Substanz. Bei den epoxidgruppenhaltigen Substanzen handelt es sich insbesondere um multifunktionelle Epoxide, also solche mit zumindest zwei Epoxidgruppen; entsprechend kommt es insgesamt zu einer mittelbaren Verknüpfung der die funktionellen Gruppen tragenden Bausteine. Die epoxidgruppenhaltigen Substanzen können sowohl aromatische als auch aliphatische Verbindungen sein.

Hervorragend geeignete multifunktionelle Epoxide sind Oligomere des Epichlorhydrins, Epoxyether mehrwertiger Alkohole (insbesondere Ethylen-, Propylen-, und Butylenglycole, Polyglycole, Thiodiglycole, Glycerin, Pentaerythrit, Sorbit, Polyvinylalkohol, Polyallylalkohol und ähnliche), Epoxyether mehrwertiger Phenole [insbesondere Resorcin, Hydrochinon, Bis-(4-hydroxyphenyl)-methan, Bis-(4-hydroxy-3-methylphenyl)-methan, Bis-(4-hydroxy-3,5-dibromphenyl)-methan, Bis-(4-hydroxy-3,5-difluorphenyl)-methan, 1,1-Bis-(4-hydroxyphenyl)ethan, 2,2-Bis-(4-hydroxyphenyl)propan, 2,2-Bis-(4-hydroxy-3-methylphenyl)-propan, 2,2-Bis-(4-hydroxy-3-chlorphenyl)-propan, 2,2-Bis-(4-hydroxy-3,5-dichlorphenyl)-propan, 2,2-Bis-(4-hydroxy-3,5-dichlorphenyl)-propan, Bis-(4-hydroxyphenyl)-phenylmethan, Bis-(4-hydroxyphenyl)-phenylmethan, Bis-(4-hydroxyphenyl)diphenylmethan, Bis (4-hydroxyphenyl)-4'-methylphenylmethan, 1,1-Bis-(4-hydroxyphenyl)-2,2,2-trichlorethan, Bis-(4-hydroxyphenyl)-(4-chlorphenyl)-methan, 1,1-Bis-(4-hydroxyphenyl)-cyclohexan, Bis-(4-hydroxyphenyl)-cyclohexylmethan, 4,4'-Dihydroxydiphenyl, 2,2'-Dihydroxydiphenyl, 4,4'-Dihydroxydiphenylsulfon] sowie deren Hydroxyethylether, Phenol-Formaldehyd-Kondensationsprodukte, wie Phenolalkohole, Phenolaldehydharze und ähnliche, S- und N-haltige Epoxide (zum Beispiel N,N-Diglycidylanillin, N,N'-Dimethyldiglycidyl-4,4-Diaminodiphenylmethan) sowie Epoxide, welche nach üblichen Verfahren aus mehrfach ungesättigten Carbonsäuren oder einfach ungesättigten Carbonsäurerestern ungesättigter Alkohole hergestellt worden sind, Glycidylester, Polyglycidylester, die durch Polymerisation oder Mischpolymerisation von Glycidylestern ungesättigter Säuren gewonnen werden können oder aus anderen sauren Verbindungen (Cyanursäure, Diglycidylsulfid, cyclischem Trimethylentrisulfon bzw. deren Derivaten und anderen) erhältlich sind.

Sehr geeignete Ether sind beispielsweise 1,4-Butandioldiglycidether, Polyglycerol-3-Glycidether, Cyclohexandimethanoldiglycidether, Glycerintriglycidether, Neopentylglykoldiglycidether, Pentaerythrittetraglycidether, 1,6-Hexandioldiglycid¬ether), Polypropylenglykoldiglycidether, Trimethylolpropantriglycidether, Penta¬erythrittetraglycidether, Bisphenol-A-diglycidether und Bisphenol-F-diglycidether.

Besonders bevorzugt ist die Verwendung eines beispielsweise in der EP 1 978 069 A1 beschriebenen Vernetzer-Beschleuniger-Systems ("Vernetzungssystem"), um eine bessere Kontrolle sowohl über die Verarbeitungszeit, Vernetzungskinetik als auch den Vernetzungsgrad zu erhalten. Das Vernetzer-Beschleuniger-System umfasst zumindest eine epoxidgruppenhaltige Substanz als Vernetzer und zumindest eine bei einer Temperatur unterhalb der Schmelztemperatur des zu vernetzenden Polymers für Vernetzungsreaktionen mittels epoxidgruppenhaltigen Verbindungen beschleunigend wirkende Substanz als Beschleuniger.

Als Beschleuniger werden besonders bevorzugt Amine (formell als Substitutionsprodukte des Ammoniaks aufzufassen; in den folgenden Formeln sind diese Substituenten durch "R" dargestellt und umfassen insbesondere Alkyl- und/oder Arylreste und/oder andere organische Reste) eingesetzt, insbesondere bevorzugt solche Amine, die mit den Bausteinen der zu vernetzenden Polymere keine oder nur geringfüge Reaktionen eingehen.

Prinzipiell können als Beschleuniger sowohl primäre (NRH₂), sekundäre (NR₂H) als auch tertiäre Amine (NR₃) gewählt werden, selbstverständlich auch solche, die mehrere primäre und/oder sekundäre und/oder tertiäre Amingruppen aufweisen. Besonders bevorzugte Beschleuniger sind aber tertiäre Amine wie beispielweise Triethylamin, Triethylendiamin, Benzyldimethylamin, Dimethylamino-methylphenol, 2,4,6-Tris-(N,N-dimethylaminomethyl)-phenol, N,N'-Bis(3-(dimethyl-amino)propyl)harnstoff. Als Beschleuniger können vorteilhaft auch multifunktionelle Amine wie Diamine, Triamine und/oder Tetramine eingesetzt werden. Hervorragend geeignet sind zum Beispiel Diethylentriamin, Triethylentetramin, Trimethylhexamethylendiamin.

Als Beschleuniger werden darüber hinaus bevorzugt Aminoalkohole verwendet. Besonders bevorzugt werden sekundäre und/oder tertiäre Aminoalkohole eingesetzt, wobei im Falle mehrerer Aminfunktionalitäten pro Molekül bevorzugt mindestens eine, bevorzugt alle Aminfunktionalitäten sekundär und/oder tertiär sind. Als bevorzugte Aminoalkoholbeschleuniger können Triethanolamin, N,N-Bis(2-hydroxypropyl)ethanolamin, N-Methyldiethanolamin, N-Ethyldiethanolamin, 2-Aminocyclohexanol, Bis(2-hydroxycyclohexyl)-methylamin, 2-(Diisopropylamino)ethanol, 2-(Dibutylamino)ethanol, N-Butyldiethanolamin, N-Butylethanolamin, 2-[Bis(2-hydroxyethyl)amino]-2-(hydroxymethyl)-1,3-propandiol, 1-[Bis(2-hydroxyethyl)-amino]-2-propanol, Triisopropanolamin, 2-(Dimethylamino)ethanol, 2-(Diethylamino)ethanol, 2-(2-Dimethylaminoethoxy)ethanol, N,N,N'-Trimethyl-N'-hydroxyethylbisaminoethylether, N,N,N'-Trimethylaminoethylethanolamin und/oder N,N,N'-Trimethylaminopropylethanolamin eingesetzt werden.

Weitere geeignete Beschleuniger sind Pyridin, Imidazole (wie beispielsweise 2-Methylimidazol) und 1,8-Diazabicyclo[5.4.0]undec-7-en. Auch cycloaliphatische Polyamine können als Beschleuniger eingesetzt werden. Geeignet sind auch Beschleuniger auf Phosphatbasis wie Phosphine und/oder Phosphoniumverbindungen, wie beispielsweise Triphenylphosphin oder Tetraphenylphosphoniumtetraphenylborat.

Weiterhin kann es vorgesehen sein, dass auch ein an sich haftklebriger Polymerschaum mit einer aus Polyacrylat(en) bestehenden Polymerbasis ober- und/oder unterseitig mit einer Haftklebemasse beschichtet ist, wobei die Polymerbasis dieser Haftklebemasse bevorzugt ebenfalls aus Polyacrylaten besteht. Es können alternativ andere beziehungsweise anders vorbehandelte Klebeschichten, also beispielsweise Haftklebeschichten und/oder hitzeaktivierbare Schichten auf der Basis anderer Polymere als Poly(meth)acrylate zu der geschäumten Schicht kaschiert werden. Geeignete Basispolymere sind Naturkautschuke, Synthesekautschuke, Acrylatblockcopolymere, Vinylaromatenblockcopolymere, insbesondere Styrolblockcopolymere, EVA, Polyolefine, Polyurethane, Polyvinylether und Silikone. Bevorzugt enthalten diese Schichten keine nennenswerten Anteile an migrierfähigen Bestandteilen, die mit dem Material der geschäumten Schicht so gut verträglich sind, dass sie in signifikanter Menge in die geschäumte Schicht diffundieren und dort die Eigenschaften verändern.

Generell kann die Weichphase des Klebebandes mindestens ein klebrig machendes Harz enthalten. Als klebrig machende Harze sind insbesondere aliphatische, aromatische und/oder alkylaromatische Kohlenwasserstoffharze, Kohlenwasserstoffharze auf Basis reiner Monomere, hydrierte Kohlenwasserstoffharze, funktionelle Kohlenwasserstoffharze sowie Naturharze einsetzbar. Bevorzugt ist das klebrig machende Harz ausgewählt aus der Gruppe umfassend Pinen-, Inden- und Kolophoniumharze, deren disproportionierte, hydrierte, polymerisierte und/oder veresterte Derivate und Salze, Terpenharze und Terpenphenolharze sowie C5-, C9- und andere Kohlenwasserstoffharze. Auch Kombinationen dieser und weiterer Harze können vorteilhaft eingesetzt werden, um die Eigenschaften der resultierenden Klebmasse wunschgemäß einzustellen. Besonders bevorzugt ist das klebrig machende Harz ausgewählt aus der Gruppe umfassend Terpenphenolharze und Kolophoniumester.

Die Weichphase des Klebebandes kann einen oder mehrere Füllstoffe enthalten. Der oder die Füllstoff(e) kann/können in einer oder in mehreren Schichten der Weichphase vorliegen.

Bevorzugt umfasst die Weichphase einen Polymerschaum, und der Polymerschaum enthält teil- oder vollexpandierte Mikroballons, insbesondere, wenn die Polymerbasis des Polymerschaums ein oder mehrere Polyacrylat(e) umfasst und ganz besonders bevorzugt, wenn die Polymerbasis des Polymerschaums aus einem oder mehreren Polyacrylat(en) besteht. Bei Mikroballons handelt es sich um elastische Hohlkugeln, die eine thermoplastische Polymerhülle aufweisen; sie werden daher auch als expandierbare polymere Mikrosphären oder als Mikrohohlkugeln bezeichnet. Diese Kugeln sind mit niedrigsiedenden Flüssigkeiten oder verflüssigtem Gas gefüllt. Als Hüllenmaterial finden insbesondere Polyacrylnitril, Polyvinyldichlorid (PVDC), Polyvinylchlorid (PVC), Polyamide oder Polyacrylate Verwendung. Als niedrigsiedende Flüssigkeit sind insbesondere niedere Alkane, beispielsweise Isobutan oder Isopentan geeignet, die als verflüssigtes Gas unter Druck in der Polymerhülle eingeschlossen sind. Durch ein physikalisches Einwirken auf die Mikroballons, beispielsweise durch eine Wärmeeinwirkung, insbesondere durch Wärmezufuhr oder -erzeugung, hervorgerufen zum Beispiel durch Ultraschall oder Mikrowellenstrahlung, erweicht einerseits die äußere Polymerhülle, gleichzeitig geht das in der Hülle befindliche flüssige Treibgas in seinen gasförmigen Zustand über. Bei einer bestimmten Paarung von Druck und Temperatur - auch als kritische Paarung bezeichnet - dehnen sich die Mikroballons irreversibel aus und expandieren dreidimensional. Die Expansion ist beendet, wenn sich der Innen- und der Außendruck ausgleichen. Da die polymere Hülle erhalten bleibt, erzielt man so einen geschlossenzelligen Schaum.

Es ist eine Vielzahl an Mikroballontypen kommerziell erhältlich, wie zum Beispiel von der Firma Akzo Nobel die Expancel DU-Typen (dry unexpanded), welche sich im Wesentlichen über ihre Größe (6 bis 45 µm Durchmesser im unexpandierten Zustand) und ihre zur Expansion benötigte Starttemperatur (75 °C bis 220 °C) differenzieren.

Weiterhin sind unexpandierte Mikroballontypen auch als wässrige Dispersion mit einem Feststoff- beziehungsweise Mikroballonanteil von ca. 40 bis 45 Gew.-% erhältlich, darüber hinaus auch als polymergebundende Mikroballons (Masterbatche), zum Beispiel in Ethylvinylacetat mit einer Mikroballonkonzentration von ca. 65 Gew.-%. Ferner sind sogenannte Mikroballon-Slurry-Systeme erhältlich, bei denen die Mikroballons mit einem Feststoffanteil von 60 bis 80 Gew.-% als wässrige Dispersion vorliegen. Sowohl die Mikroballon-Dispersionen, die Mikroballon-Slurrys als auch die Masterbatche sind wie die DU-Typen zur Schäumung eines in der Weichphase des Klebebandes enthaltenen Polymerschaums geeignet.

Besonders bevorzugt enthält der Polymerschaum Mikroballons, die im nicht expandierten Zustand bei 25 °C einen Durchmesser von 3 µm bis 40 µm, insbesondere von 5 µm bis 20 µm, und/oder nach Expansion einen Durchmesser von 10 µm bis 200 µm, insbesondere von 15 µm bis 90 µm, aufweisen.

Bevorzugt enthält der Polymerschaum bis zu 30 Gew.-% Mikroballons, insbesondere zwischen 0,5 Gew.-% und 10 Gew.-%, jeweils bezogen auf die Gesamtmasse des Polymerschaums.

Der Polymerschaum der Weichphase des Klebebandes, sofern diese einen Polymerschaum umfasst, ist bevorzugt gekennzeichnet durch die weitgehende Abwesenheit von offenzelligen Hohlräumen. Besonders bevorzugt weist der Polymerschaum einen Anteil von Hohlräumen ohne eigene Polymerhülle, also von offenzelligen Kavernen, von nicht mehr als 2 Vol-% auf, insbesondere von nicht mehr als 0,5 Vol.-%. Der Polymerschaum ist somit bevorzugt ein geschlossenzelliger Schaum.

Optional kann die Weichphase des Klebebandes auch pulver- und/oder granulatförmige Füllstoffe, Farbstoffe und Pigmente, insbesondere auch abrasive und verstärkende Füllstoffe, wie zum Beispiel Kreiden (CaCO3), Titandioxide, Zinkoxide und Ruße, auch zu hohen Anteilen, das heißt von 0,1 bis 50 Gew.-% bezogen auf die Gesamtmasse der Weichphase, enthalten.

Weiterhin können schwerentflammbare Füllstoffe wie beispielsweise Ammoniumpolyphosphat; elektrisch leitfähige Füllstoffe wie beispielsweise Leitruß, Kohlenstofffasern und/oder silberbeschichtete Kugeln; thermisch leitfähige Materialien wie beispielsweise Bornitrid, Aluminiumoxid, Siliziumcarbid; ferromagnetische Additive wie beispielsweise Eisen-(III)-oxide; weitere Additive zur Volumenerhöhung wie beispielsweise Blähmittel, Glasvollkugeln, Glashohlkugeln, carbonisierte Mikrokugeln, phenolische Mikrohohlkugeln, Mikrokugeln aus anderen Materialien; Kieselsäure, Silicate, organisch nachwachsende Rohstoffe wie beispielsweise Holzmehl, organische und/oder anorganische Nanopartikel, Fasern; Alterungsschutzmittel, Lichtschutzmittel, Ozonschutzmittel und/oder Compoundierungsmittel in der Weichphase enthalten sein. Als Alterungsschutzmittel können bevorzugt sowohl primäre, z. B. 4-Methoxyphenol oder Irganox^{®} 1076, als auch sekundäre Alterungsschutzmittel, z. B. Irgafos^{®} TNPP oder Irgafos^{®} 168 der Firma BASF, gegebenenfalls auch in Kombination miteinander, eingesetzt werden. Als weitere Alterungsschutzmittel können Phenothiazin (C-Radikalfänger) sowie Hydrochinonmethylether in Gegenwart von Sauerstoff sowie Sauerstoff selbst eingesetzt werden.

Die Dicke der Weichphase beträgt vorzugsweise 200 bis 1800 µm, besonders bevorzugt 300 bis 1500 µm, insbesondere 400 bis 1000 µm. Die Dicke der Weichphase wird nach ISO 1923 bestimmt.

Die Verbindung von Hart- und Weichphase beziehungsweise auch von in der Hart- und/oder Weichphase vorgesehenen Schichten untereinander zum Klebeband kann beispielsweise durch Laminieren, Kaschieren oder Coextrusion erfolgen. Es ist möglich, dass Hart- und Weichphase direkt, das heißt unmittelbar, miteinander verbunden sind. Ebenso ist es möglich, dass zwischen Hart- und Weichphase eine oder mehrere haftvermittelnde Schicht(en) angeordnet ist/sind. Das Klebeband kann darüber hinaus weitere Schichten enthalten.

Bevorzugt ist mindestens eine der miteinander zu verbindenden Schichten, stärker bevorzugt sind mehrere der miteinander zu verbindenden Schichten und ganz besonders bevorzugt sind alle der miteinander zu verbindenden Schichten mit Corona- (mit Luft oder Stickstoff), Plasma-(Luft, Stickstoff oder andere reaktive Gase beziehungsweise reaktive, als Aerosol einsetzbare Verbindungen) oder Flammenvorbehandlungsmethoden vorbehandelt.

Auf der Rückseite, das heißt auf der vom Substrat abgewandten Seite der Hartphase, ist bevorzugt eine Funktionsschicht aufgebracht, die beispielsweise Trenneigenschaften oder UV-stabilisierende Eigenschaften aufweist. Diese Funktionsschicht besteht bevorzugt aus einer Folie mit einer Dicke von ≤ 20 µm, besonders bevorzugt von ≤ 10 µm, insbesondere von ≤ 8 µm, beispielsweise von ≤ 5 µm oder einem Lack mit einer Dicke von ≤ 10 µm, besonders bevorzugt von ≤ 6 µm, insbesondere von ≤ 3 µm, beispielsweise von ≤ 1,5 µm. Sowohl die Folie als auch der Lack enthalten bevorzugt einen UV-Absorber, und/oder die Polymerbasis der Folie beziehungsweise des Lacks enthält UV-absorbierende und/oder UV-abweisende Gruppen.

Folien können durch Laminieren, Kaschieren oder Coextrusion auf die Rückseite der Hartphase aufgebracht werden. Bei der Folie handelt es sich bevorzugt um eine metallisierte Folie. Die Polymerbasis der Folie ist bevorzugt ausgewählt aus der Gruppe bestehend aus Polyarylenen, Polyvinylchloriden (PVC), Polyethylenterephthalaten (PET), Polyurethanen, Polyolefinen, Polyutylenterephthalaten (PBT), Polycarbonaten, Polymethylmethacrylaten (PMMA), Polyvinylbutyralen (PVB), Ionomeren und Mischungen aus zwei oder mehreren der vorstehend aufgeführten Polymere. "Hauptbestandteil" bedeutet hier "Bestandteil mit dem größten Gewichtsanteil bezogen auf das Gesamtgewicht der Folie". Mit Ausnahme der Polyarylene weisen alle aufgeführten Materialien der Folie bevorzugt einen hohen Gehalt an UV-Stabilisatoren auf.

In einer speziellen Ausführungsform besteht das Klebeband in auf das Substrat gerichteter Reihenfolge aus einer Funktionsschicht (wie vorstehend beschrieben), einer Hartphase und einer Weichphase bestehend aus einer Haftklebeschicht, einem Polymerschaum, dessen Polymerbasis aus einem oder mehreren Polyolefinen besteht, und einer weiteren Haftklebeschicht. Die untere Haftklebeschicht kann mit einem Releaseliner abgedeckt sein, dieser wird jedoch nicht zum Klebeband gerechnet.

In einer weiteren speziellen Ausführungsform besteht das Klebeband in auf das Substrat gerichteter Reihenfolge aus einer Funktionsschicht (wie vorstehend beschrieben), einer Hartphase und einer haftklebrigen Weichphase, deren Polymerbasis aus einem oder mehreren Polyacrylaten besteht. Auch bei dieser Ausführungsform kann die Unterseite, das heißt die dem Substrat zugewandte Seite, der Weichphase mit einem Releaseliner abgedeckt sein, dieser wird jedoch nicht zum Klebeband gerechnet.

Bevorzugt handelt es sich bei den Klebebändern um geschäumte Acrylatmassen, insbesondere der oben beschriebenen Art, die zusätzlich einen (oder mehrere) Zwischenträger haben können.

Erfindungswesentlich für das Verfahren ist, dass insbesondere außen auf die Seitenkanten des Klebebandes während der Herstellung des Klebebandes oder auch nach dem Aufkleben des Klebebandes auf eine Substratoberfläche eine hydrophobe Passivierungsschicht mittels eines Plasmastromes aufgebracht wird. Vorzugsweise wird ein Athmosphärendruckplasmaverfahren verwendet.

Die Gefahr der Feuchtehinterwanderung in eine Verklebung wird dadurch verhindert, dass außen auf die Seitenkante der Klebmasseschicht eine hydrophobe Passivierungsschicht mittels eines Plasmastromes aufgebracht wird. Üblicherweise ist nach dem Aufbringen des Klebebandes zwischen zwei Substratflächen, die zusammengeklebt werden, nur der außen das Klebeband umlaufende Seitenrand frei und der Gefahr einer Feuchtehinterwanderung durch Wasser und Luftfeuchtigkeit ausgesetzt.

Der freie Seitenrand wird mit einer hydrophoben Passivierungsschicht versehen. Dafür wird erfindungsgemäß ein Plasmaverfahren verwendet. Die Behandlung der Seitenkante der Klebmasseschicht erfolgt bei oder nahe bei Atmosphärendruck.

Zur Durchführung des Plasmaverfahrens wird ein Aufbau mit einer Plasmadüse verwendet, der ein zu ionisierendes Prozessgas, vorzugsweise in Form von Umgebungsluft, zugeführt wird. Des Weiteren wird dem Ausgang der Plasmadüse ein Präkursor zugeführt. Bei dem Präkursor handelt es sich um Silane oder Siloxane, die verdampft und mittels eines Trägergases, beispielsweise Stickstoff oder Edelgas, in den Plasmastrom eingeleitet werden. Bei dem Präkursor handelt es sich um Aminopropyltriethoxysilan, Perfluoroctyltriethoxysilan oder Hexamethyldisiloxan. Eine reine Siliziumoxidschicht ist bei der Polimerisation, also dem Auftragen des Plasmastromes auf die Substratoberfläche, nicht zu erwarten. Der Anteil von Kohlenstoff durch nicht umgesetzte Kohlenwasserstoffketten aus dem Präkursormolekül, also bei Hexamethyldisiloxan die Hexamethylketten, kann bei bis zu 12 %-Gewichtsanteile der Beschichtung liegen. Durch diesen zusätzlichen Gewichtsanteil in der Silizumoxidschicht wird ein Hydrophobierungseffekt erzielt. Die nicht wasserliebende Schicht lässt durch das Abperlen von Wassertropfen die Klebebandseiten und Grenzschichten einer Verklebung wasserfrei. Dadurch wird das flüssige Medium, also das kondensierte Wasser, von der Einflusszone der Verklebung abgeführt, und eine Migration des Wassers kann aufgrund der Polarität des Wassers in die Verklebung nicht stattfinden.

Das in dem erfindungsgemäßen Verfahren verwendbare Klebeband weist eine Klebmasseschicht mit einer Längsausdehnung und zumindest einer entlang der Längsausdehnung verlaufenden Seitenkante auf. Entlang der Seitenkante der Klebmasseschicht ist eine hydrophobe Passivierungsschicht aufgetragen. Die hydrophobe Passivierungsschicht wird gemäß einem der oben genannten Verfahren aufgebracht.

In einer bevorzugten Ausführungsform des Klebebandes ist die hydrophobe Passivierungsschicht als eine SiOx-Schicht mit einem Gewichtsanteil von bis zu 12 % Kohlenstoff ausgebildet.

Die hydrophobe Passivierungsschicht wird vorzugsweise in einem Atmosphärendruckplasmaverfahren mit einem der oben genannten Präkusoren, insbesondere HMDSO, unter Verwendung von Umgebungsluft als Prozessgas hergestellt.

Günstigerweise weist die Klebmasseschicht wenigstens zwei, vorzugsweise genau zwei Seitenkanten auf, die mit der hydrophoben Passivierungsschicht versehen sind. Vorzugsweise handelt es sich bei der Klebmasseschicht um eine Schicht eines auf eine Rolle aufgewickelten Klebebandes.

Die Klebmasseschicht kann wenigstens ein Elastomer und ein Reaktivharz umfassen. Hinsichtlich des Aufbaus des Elastomers und des Reaktivharzes wird auf die obigen Ausführungen verwiesen. Die Klebmasseschicht kann auch eine haftklebrige Weichphase umfassen. Auch diesbezüglich wird auf die obigen Ausführungen verwiesen.

Die Erfindung wird anhand eines Ausführungsbeispiels in zwei Figuren beschrieben. Dabei zeigen:
- Fig. 1: einen prinzipiellen Aufbau einer verwendeten Plasmadüse,
- Fig. 2: eine Balkengrafik zur Bewertung des Effektes der Plasmarandverkapselung.

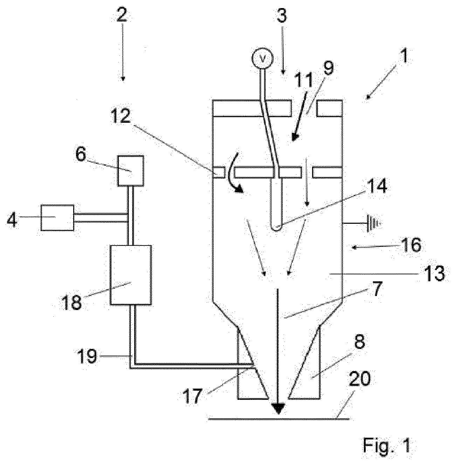

Fig. 1 zeigt die prinzipielle Ansicht einer Plasmadüse 1, dabei handelt es sich um ein OpenAir-System der *Plasmatreat* GmbH.

Eine Plasmadüse 1 umfasst eine Präkursoreinheit 2, die in der Fig. 1 links dargestellt ist, und eine Plasmaeinheit 3. Die Präkursoreinheit 2 erzeugt ein mit einem Präkursor 4 angereichertes Trägergas 6, während die Plasmaeinheit 3 ein Plasma 7 erzeugt. Der Präkursor 4 und das Plasma 7 werden in einem Düsenkopf 8 zusammengeführt.

Unter dem Plasma 7 wird hier ein hochenergetisches Prozessgas 11, insbesondere ein angeregtes und ionisiertes Luft-Stickstoff-Gemisch verstanden. Zur Erzeugung wird zunächst der Plasmaeinheit 3 durch einen Einlass 9 das Prozessgas 11 zugeführt, bei dem Prozessgas 11 handelt es sich hier um Luft oder Stickstoff oder ein Gemisch daraus. Das Prozessgas 11 wird durch den Einlass 9 in die Plasmaeinheit 3 eingeleitet und gelangt durch eine Blende 12 mit Bohrungen in eine Entladungszone 13, durch die das Prozessgas 11 hindurchströmt. In der Entladungszone 13 wird das Prozessgas 11 an einer Elektrodenspitze 14 vorbeigeführt, an der eine hochfrequente Wechselspannung mit einigen Kilovolt und einer Frequenz von 10 kHz angeschlossen ist. Zwischen der Elektrodenspitze 14 und einer Gegenelektrode, die beispielsweise ein geerdetes Edelstahlgehäuse 16 sein kann, entsteht ein starkes elektrisches Wechselfeld, das zu einer sogenannten Coronarentladung führt, die das durch die Plasmaeinheit 3 an der Elektrodenspitze 14 vorbeiströmende Prozessgas 11 ionisiert und in einen Strom des Plasmas 7 umwandelt. Das Plasma 7 wird durch den Düsenkopf 8 geführt, an dem an einem seitlichen Einlass 17 die Präkursoreinheit 2 angeschlossen ist.

Der seitliche Einlass 17 des Düsenkopfes 8 ist mit der Präkursoreinheit 2 verbunden. Die Präkursoreinheit 2 umfasst eine erste Zufuhr für den Präkursor 4 und eine zweite Zufuhr für das Trägergas 6. Als Trägergas 6 kann hier ebenfalls Luft oder Stickstoff oder ein Gemisch aus Luft und Stickstoff verwendet werden. Der Präkursor 4 wird zerstäubt und dem Trägergas 6 tröpfchenförmig zugeführt, das Gemisch gelangt in einen Verdampfer 18, wo Temperaturen oberhalb des Siedepunktes des Präkursors 4 herrschen. Als Präkursor 4 kann ein organisches polyfunktionelles Silan verwendet werden, beispielsweise Hexamethyldisiloxan (HMDSO).

Bei dem hier verwendeten Präkursor 4 handelt es sich um Hexamethyldisiloxan (HMDSO), das dem Trägergas 6 in einer Größenordnung von 10, 20, 40 g/h bis zu 150 g/h zugeführt wird. Die Temperatur im Verdampfer 18 liegt bei etwa 120 °C, also oberhalb der Siedetemperatur von HMDSO, die etwa bei 100 °C liegt.

Ein dem Verdampfer 18 entweichendes Präkursorgas 19 wird dem Düsenkopf 8 zugeführt und dort mit dem Plasma 7 vermengt. Der Präkursor 4 gelangt so mit dem Plasma 7 auf eine Seitenkante einer Klebmasseschicht 20.

Die Plasmadüse 1 steht in einem senkrechten Winkel zur Seitenkante der Klebmasseschicht 20 und mündet in den Düsenkopf 8.

Die Behandlung der Seitenkante der Klebmasseschicht 20 findet bei oder nahe bei Atmosphärendruck statt, wobei der Druck in der elektrischen Entladungszone 13 der Plasmadüse 1 auch höher sein kann. Unter einem Plasma 7 wird in diesem Ausführungsbeispiel ein Atmosphärendruckplasma verstanden, das ein elektrisch aktiviertes homogenes reaktives Gas ist, das sich nicht im thermischen Equilibrium befindet, mit einem Druck nahe dem Umgebungsdruck in seinem Wirkbereich. Im Allgemeinen beträgt der Druck 0,5 bar mehr als der Umgebungsdruck. Durch die elektrischen Entladungen oder durch die Ionisierungsprozesse im elektrischen Feld der Entladungszone 13 wird das Prozessgas 11 aktiviert, und es werden hochangeregte Zustände in den Gasbestandteilen erzeugt. Dem Prozessgas 11 wird dann in dem Düsenkopf 8 über einen gasleitenden Kanal über den seitlichen Einlass 17 der Präkursor 4 in Gasform oder als Aerosol zugeführt, der die eigentliche Siliziumoxidschicht auf der Oberfläche der Seitenkante der Klebmasseschicht ausbildet.

Als Prozessgas 11 wird hier Umgebungsluft verwendet.

In einem Ausführungsbeispiel wurde für die Seitenkantenverkapselung folgender Aufbau mit nachfolgenden Bedingungen und Parametern verwendet:
Plasmadüse: Generator FG 5001, feste Düse 216028WE (Fa. Plasmatreat)
Präkursor: Hexamethyldisiloxan (HMDSO),
Präkursormenge: 10 - 150 g/Stunde
Behandlungsgeschwindigkeit: 40 m/min
Abstand der Düse: 15 mm
PCT (Pulse-Cycle-Time): 20 % und 100 %
Verdampfertemperatur: 120 °C

Grundsätzlich führen nanobeschichtete Seitenkanten dazu, dass die Aufnahme von Wasser in die Klebmasse, insbesondere die Trägerbausteine von ACX^{plus}, reduziert wird. Dies wird besonders bei Parametereinstellungen erreicht, die vorrangig eine glasartige Abscheidung mit geringen organischen Anteilen erzeugen. Beispielhaft kann das ACX^{plus} 6812 genannt werden, welches deutliche Verbesserungen bei Belastungen wie z. B. damp heat 85/85 und 40 °C bei 100 % rel. Feuchte zeigen. Darüber hinaus sind Präkursoren interessant, die eine ausgeprägte Hydrophobierung einbringen können. Klebefugen sind normalerweise unter den Prüfbedingungen mit einer Wasserschicht dauerhaft benetzt, da die Inhaltsstoffe der Klebeprodukte ausreichend polare Gruppen beinhalten. Dies fördert die Migration von Wassermolekülen ins Bulk des Klebeproduktes sowie die Einwanderung von Feuchtigkeit in die Grenzschicht. Hydrophobe Eigenschaften einer Klebefuge provozieren das "Abführen" von Wasser als Tropfen und verhindern die Ausbildung eines geschlossenen Wasserfilms. Erste Ergebnisse mit hydrophob wirkenden Präkursoren können eine signifikante Verbesserung für eine Feucht-Warm-Resistenz bewirken, die höhere Festigkeitswerte als die Referenz ohne Lagerung zeigen. Zum Einsatz kamen die Präkursoren Octyltriethoxysilane (OCS), (3-Glycidyloxypropyl)trimethoxysilane (GLYMO) und das Hexamethyldisiloxan (HMDSO). Über die Modifizierung der Plasmaparameter (Leistung, Abstand, Geschwindigkeit und Puls-Cycle-Time) ist es möglich, den organischen Anteil der aufgetragenen Schicht zu beeinflussen. Bei der Deaktivierung von Klebmassen ist die Parameterwahl bewusst auf den gesamten Umsatz des Präkursors ausgerichtet, um den überwiegend organischen Anteil für eine glasartige Schicht durch die Plasmapolymerisation zu entfernen. Hier verfolgt man das entgegengesetzte Ziel, um die Hydrophobierung hoch einzustellen. Zudem wurde die Flussrate des Präkursors erhöht.

Beschichtungen mit einem Atmosphärendruckplasma führen z. B. bei HMDSO zu glasartigen Schichten auf dem Substrat. Dabei ist es aber bei geeigneter Parameterführung (Puls-Weiten-Modulation) möglich, die Umsetzung des HMDO zu beeinflussen. Eine reine SiOx-Schicht ist bei dieser Polymerisation nicht zu erwarten. Der Anteil von Kohlenstoff durch nicht umgesetzte KW-Ketten aus dem Präkursormolekül (bei HMDSO die Hexamethyl-Kette) kann bei bis zu 12 %-Gewichtsanteil der Beschichtung liegen. Dies führt zu einer Hydrophobierung. Diese nicht wasserliebende Schicht lässt durch das Abperlen von Wassertropfen die Klebebandseiten und die Grenzschichten einer Verklebung wasserfrei. Letztlich wird das flüssige Medium von der Einflusszone, bei der die negative Auswirkung auf die Haftung stattfindet, abgeführt, und eine Migration kann durch die Polarität nicht stattfinden (siehe Film mit hydrophobiertem Zellstoff und ohne Behandlung).

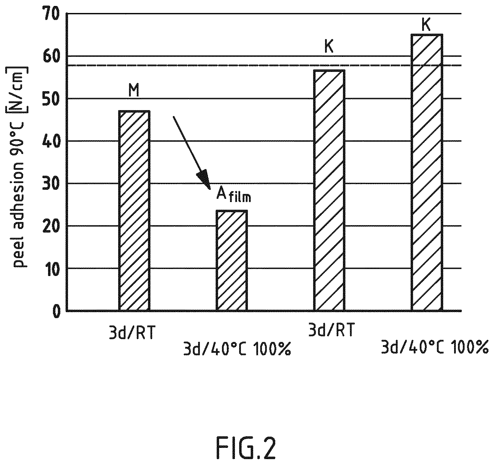

Fig. 2 stellt eine Balkengrafik zur Bewertung des Effektes der Plasmarandverkapselung dar. Sie zeigt die Klebkraft von ACX^{plus} 6812 auf Polypropylen (PP) nach drei Tagen (3d) bei Raumtemperatur (RT) und nach drei Tagen bei 40 °C und 100 % relativer Luftfeuchtigkeit. Dabei ist bei den beiden linken Balken keine Passivierung der Seitenränder vorgenommen worden, und rechts ist eine Passivierung der Seitenränder vorgenommen worden. Die Klebkraft wurde bei einem Abzugwinkel von 90° bestimmt. Es zeigt sich eine deutliche Erhöhung der Klebkraft durch die Passivierung der Seitenränder. Dieser Effekt tritt insbesondere und stärker bei hoher Luftfeuchtigkeit auf.

Die in der Balkengrafik dargestellte gestrichelte Linie stellt die Klebkraft bei kohäsivem Spalten der Verklebung dar. Eine oben über die gestrichelte Linie hinausgehende Klebkraft ist auf unterschiedliche Messaufbauten, Messfehler usw. zurückzuführen. Deutlich wird an der Balkengrafik jedenfalls, dass die Plasmawandverkapselung zu einer deutlich erhöhten Klebkraft führt, insbesondere eine längere Lagerung ermöglicht.

Durch die Randverkapselung wird die Barrierefunktion gegen migrationsfähige Substanzen, insbesondere gegen Gasdiffusion, verringert, wie nachfolgende Tabelle zeigt:

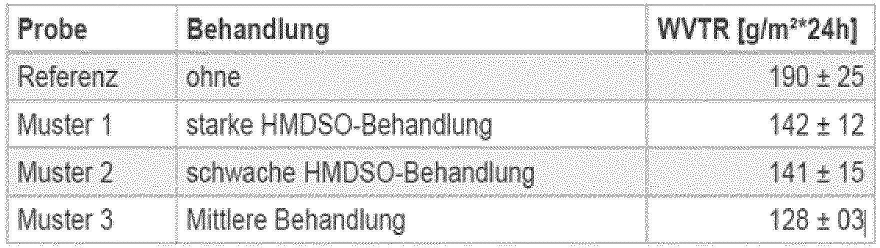

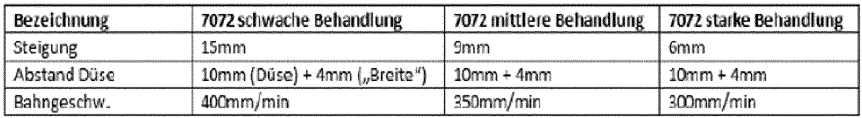

Die HMDSO Behandlung steht hier exemplarisch für eine Behandlung für siloxanhaltige Präkursoren. Die Behandlung wurde mit der oben genannten Plasmadüse: Generator FG 5001, feste Düse 216028WE der Firma Plasmatreat durchgeführt. Die Ergebnisse zeigen, dass die Permeabilität durch die Plasmabehandlung deutlich gesenkt werden kann.

### Bezugszeichenliste

- 1: Plasmadüse
- 2: Präkursoreinheit
- 3: Plasmaeinheit
- 4: Präkursor

- 6: Trägergas
- 7: Plasma
- 8: Düsenkopf
- 9: Einlass

- 11: Prozessgas
- 12: Blende
- 13: Entladungszone
- 14: Elektrodenspitze

- 16: geerdetes Edelstahlgehäuse
- 17: seitlicher Einlass
- 18: Verdampfer
- 19: Präkursorgas
- 20: Klebmasseschicht

## Patentansprüche

1. Verfahren zur Reduzierung der Feuchtehinterwanderung in eine Verklebung, indem ein Klebeband mit einer Klebmasseschicht (20) auf eine Substratoberfläche aufgeklebt wird und außen entlang einer Seitenkante der Klebmasseschicht (20) eine hydrophobe Passivierungsschicht mittels eines Plasmastromes aufgebracht wird, wobei dem Plasmastrom ein Präkursor (4) zugeführt wird und als Präkursor (4) Silane und/oder Siloxane verwendet werden und
der Präkursor (4) aus der Gruppe Aminopropyltriethoxysilan, Perfluoroctyltriethoxysilan, HMDSO gewählt wird.

2. Verfahren nach Anspruch 1,
**dadurch gekennzeichnet, dass**
der Präkursor (4) verdampft wird und mittels eines Inertgases in den Plasmastrom transportiert wird.

3. Verfahren nach zumindest einem der vorstehenden Ansprüche,
**dadurch gekennzeichnet, dass**
ein Prozessgas (11) angeregt wird und Umgebungsluft als Prozessgas (11) verwendet wird.

4. Verfahren nach zumindest einem der vorstehenden Ansprüche,
**dadurch gekennzeichnet, dass**
die Klebmasseschicht (20) wenigstens ein Elastomer und ein Reaktivharz umfasst.

5. Verfahren nach Anspruch 4,
**dadurch gekennzeichnet, dass**
das Elastomer aus der Gruppe Vinylaromate, Methylmethacrylat, Cyclohexylmethacrylat, Isobornylmethacrylat und Isobornylacrylat oder aus der Gruppe Polyether, oder aus der Gruppe Polydiene, oder Polyisopren, teilhydrierte oder hydrierte Polydiene, oder Polybutylenbutadien, Polybutylen, Polyisobutylen, Polyalkylvinylether, Polymerblöcke α,β-ungesättigter Ester gewählt wird.

6. Verfahren nach zumindest einem der vorstehenden Ansprüche,
**dadurch gekennzeichnet, dass**
als Klebmasseschicht (20) eine haftklebrige Weichphase verwendet wird.

7. Verfahren nach Anspruch 6,
**dadurch gekennzeichnet, dass**
als haftklebrige Weichphase ein haftklebriger Polymerschaum verwendet wird, der ein oder mehrere Polyacrylate umfasst.

8. Verfahren nach Anspruch 7,
**dadurch gekennzeichnet, dass**
die Polyacrylate umfassen:
(a) Acrylsäureester und/oder Methacrylsäureester der folgenden Formel
CH₂ = C(R^{I})(COOR^{II})
wobei R^{I} = H oder CH₃ und R^{II} ein Alkylrest mit 4 bis 14 C-Atomen ist,
(b) olefinisch ungesättigte Monomere mit funktionellen Gruppen der für eine Reaktivität mit Epoxidgruppen bereits definierten Art,
(c) weitere Acrylate und/oder Methacrylate und/oder olefinisch ungesättigte Monomere, die mit der Komponente (a) copolymerisierbar sind.

## Claims

1. Method for reducing rearward infiltration of moisture into an adhesive bond, by adhering an adhesive tape with a layer (20) of adhesive to a substrate surface and, by means of a plasma stream, applying a hydrophobic passivation layer externally along one side edge of the layer (20) of adhesive, wherein a precursor (4) is supplied to the plasma stream and the precursor (4) used comprises silanes and/or siloxanes and the precursor (4) is selected from the group of aminopropyltriethoxysilane, perfluorooctyltriethoxysilane and HMDSO.

2. Method according to Claim 1,
**characterized in that** the precursor (4) is evaporated and transported into the plasma stream by means of an inert gas.

3. Method according to at least one of the preceding claims,
**characterized in that** a process gas (11) is excited and ambient air is used as process gas (11).

4. Method according to at least one of the preceding claims, **characterized in that** the layer (20) of adhesive comprises at least an elastomer and a reactive resin.

5. Method according to Claim 4,
**characterized in that** the elastomer is selected from the group of vinylaromatics, methyl methacrylate, cyclohexyl methacrylate, isobornyl methacrylate and isobornyl acrylate or from the group of polyethers, or from the group of polydienes, or polyisoprene, semi- hydrogenated or hydrogenated polydienes, or polybutylene-butadiene, polybutylene, polyisobutylene, polyalkyl vinyl ethers, and polymer blocks of α,β-unsaturated esters.

6. Method according to at least one of the preceding claims,
**characterized in that** the layer (20) of adhesive used comprises a pressure-sensitively tacky soft phase.

7. Method according to Claim 6,
**characterized in that** the pressure-sensitively tacky soft phase used comprises a pressure-sensitively tacky polymer foam which comprises one or more polyacrylates.

8. Method according to Claim 7,
**characterized in that** the polyacrylates comprise:
(a) acrylic esters and/or methacrylic esters of the following formula
CH₂=C(R^{I})(COOR^{II})
where R^{I} = H or CH₃ and R^{II} is an alkyl radical having 4 to 14 carbon atoms,
(b) olefinically unsaturated monomers having functional groups of the type already defined for reactivity with epoxide groups,
(c) further acrylates and/or methacrylates and/or olefinically unsaturated monomers which are copolymerizable with component (a).

## Revendications

1. Procédé de réduction de l'infiltration d'humidité par l'arrière dans un collage, par collage d'un ruban adhésif comportant une couche de masse adhésive (20) sur une surface de substrat, une couche de passivation hydrophobe étant appliquée à l'aide d'un courant de plasma le long d'une arête latérale de la couche de masse adhésive (20), un précurseur (4) étant amené au courant de plasma, le précurseur (4) utilisé étant des silanes et/ou des siloxanes, et le précurseur (4) étant choisi dans le groupe aminopropyltriéthoxysilane, perfluorooctyltriéthoxysilane, HMDSO.

2. Procédé selon la revendication 1, **caractérisé en ce qu'**on vaporise le précurseur (4) et on le transporte dans le courant de plasma à l'aide d'un gaz inerte.

3. Procédé selon au moins l'une des revendications précédentes, **caractérisé en ce qu'**on excite un gaz de procédé (11), et qu'on utilise comme gaz de procédé (11) de l'air ambiant.

4. Procédé selon au moins l'une des revendications précédentes, **caractérisé en ce que** la couche de masse adhésive (20) comprend au moins un élastomère et une résine réactive.

5. Procédé selon la revendication 4, **caractérisé en ce que** l'élastomère est choisi dans le groupe composés vinylaromatiques, méthacrylate de méthyle, méthacrylate de cyclohexyle, méthacrylate d'isobornyle et acrylate d'isobornyle ou dans le groupe polyéthers ou dans le groupe polydiènes, ou polyisoprène, polydiènes hydrogénés ou partiellement hydrogénés, ou polybutylènebutadiène, polybutylène, polyisobutylène, polyalkylvinyléther, blocs polymères d'esters α, β-insaturés.

6. Procédé selon au moins l'une des revendications précédentes, **caractérisé en ce qu'**on utilise comme couche de masse adhésive (20) une phase souple adhésive de contact.

7. Procédé selon la revendication 6, **caractérisé en ce qu'**on utilise comme phase souple adhésive de contact une mousse polymère adhésive de contact, qui comprend un ou plusieurs polyacrylates.

8. Procédé selon la revendication 7, **caractérisé en ce que** les polyacrylates comprennent :
(a) des esters d'acide acrylique et/ou des esters d'acide méthacrylique ayant la formule suivante
CH₂=C(R^{I})(COOR^{II}),
dans laquelle R^{I} = H ou CH₃ et R^{II} représente un radical alkyle ayant 4 à 14 atomes de carbone,
(b) des monomères à insaturation oléfinique comportant des groupes fonctionnels du type déjà défini pour une réactivité avec des groupes époxydes,
(c) d'autres acrylates et/ou méthacrylates et/ou monomères à insaturation oléfinique qui sont copolymérisables avec le composant (a).
